# EUROPEAN PATENT SPECIFICATION

(11) **EP 1 856 543 B1**
(45) Date of publication and mention of the grant of the patent: **30.12.2020**
(21) Application number: 06716969.8
(22) Date of filing: 06.03.2006
(51) Int. Cl.: G01R 19/145, G01R 13/02, G02B 6/44, H05B 33/12, G01R 13/40, H01B 7/36, H01R 13/66, H01R 13/717

(54) **VISUALISATION ARRANGEMENT**
VISUALISIERUNGS-ANORDNUNG
AGENCEMENT DE VISIONNEMENT

(30) Priority: 07.03.2005 SE 0500523
(43) Date of publication of application: 21.11.2007
(60) Divisional application: 20178068.1
(73) Proprietor: Counterflo AB, 115 24 Stockholm (SE)
(72) Inventor: GUSTAFSSON, Anton, 17674 Järfälla (SE); GYLLENSWÄRD, Magnus, S-112 30 Stockholm (SE); ÖHMAN, Christina, S-132 47 Saltsjö-Boo (SE); ILSTEDT-HJELM, Sara, S-181 31 Lidingö (SE)
(74) Representative: Valea AB
(86) International application number: PCT/SE2006/000283
(87) International publication number: WO 2006/096115

(56) References cited:
- WO-A1-2005/052443
- JP-A- 2000 195 682
- KR-Y1- 200 225 528
- US-A- 5 122 733
- US-A- 5 781 015
- US-A- 5 900 804
- US-A- 5 917 288
- US-A- 6 147 484
- US-A1- 2002 039 666
- US-A1- 2004 022 052
- US-A1- 2004 247 262
- US-B1- 6 169 491
- US-B1- 6 347 172
- US-B1- 6 377 054
- ANTON GUSTAFSSON ET AL: "The power-aware cord", CHI '05 EXTENDED ABSTRACTS ON HUMAN FACTORS IN COMPUTING SYSTEMS , CHI '05, 2 April 2005 (2005-04-02), pages 1423-1426, XP055045675, New York, New York, USA DOI: 10.1145/1056808.1056932 ISBN: 978-1-59-593002-6

## Description

### TECHNICAL FIELD OF THE INVENTION

The present invention relates to a visualisation arrangement, especially formed as a cable or wire surrounding, for visualisation of current and/or power consumption.

### BACKGROUND OF THE INVENTION

Electricity is an invisible phenomenon. Usually, the state of the electrical equipment is indicated using some form of illuminator such as LEDs arranged in a housing. The light from the illuminator indicates whether the equipment is on or off.

US 6,347,172 describes an optically observable cable and a method of manufacturing the same. The optically observable cable includes a conduit for conducting signals and a side-emitting optical fiber disposed on a periphery of the conduit and extending along a length of the conduit, and a cable jacket encapsulating the conduit and the side-emitting optical fiber, wherein the cable jacket is at least partially translucent such that the side-emitting optical fiber is optically exposed through the cable jacket. A method of detecting individual cables from amongst a plurality of signal transmission cables each having a side-emitting optical fiber includes positioning a light source at an interface which houses and end of a cable to be detected, transmitting light from the light source into the interface, and observing light emitted from an axis of a cable to be detected. This invention aims to solve the problem of identifying different cables in a large number of cable structures.

In the prior art, materials emitting light when an electric current passes through them are well known and used in a wide range of display applications. Typical electroluminescent devices comprise an anode, normally of an electrically light transmitting material, a layer of a hole transporting material, a layer of the electroluminescent material, optionally a layer of an electron transmitting material and a metal cathode. There can be other layers, such as buffer layers and the layers can be combined using mixtures of one or more of the hole transporting material, electroluminescent material and the electron transmitting material.

For example WO 03/093394 relates to an electroluminescent device having a layer which emits light in the blue, purple/blue or ultraviolet section of the spectrum and a layer which contains a fluorescent material and optionally a layer comprising one or more color filters so that light emitted by the electroluminescent layer excites the fluorescent material causing light to be emitted at a longer wavelength.

US 2002/0039666 relates to an electric luminescence fiber, which can be maintained in any desired shape and can be used in wider applications. The invention provides a flexible luminescence substance produced by arranging electrode wires in electric luminescence powder, said electric luminescence substance is coated with thermoplastic resin, thermosetting resin, or UV-setting resin. The coated resin is hardened and stabilized in linear or other desired shape, and the electric luminescence substance inside the coated resin is maintained in the desired shape.

### SUMMARY OF THE INVENTION

The present invention provides an arrangement for indicating the level of current and/or power consumption of one or several apparatuses. Mainly, the invention provides an arrangement for indicating the load a power cable is exposed to.

For these reasons, an arrangement according to claim 1 is provided. According to one embodiment, the wire shaped illuminator is electroluminescent. According to another embodiment, the wire shaped illuminator is an optical fibre.

The controller is further adapted to measure the electrical quantity and adapt a control signal to control the illuminator. The controller comprises a processing arrangement and a measuring arrangement and a driver for driving the illuminator receiving control signals from the processing arrangement.

According to preferred embodiments, the illumination feature is one or several of intensity, colour or frequency.

### BRIEF DESCRIPTION OF THE DRAWINGS

In the following, the invention will be further described in a non-limiting way with reference to the accompanying drawings in which:
- Fig. 1: schematically illustrates a part of an arrangement according to a preferred embodiment of the invention in perspective,
- Fig. 2: is a cross sectional view through a cord arrangement of Fig. 1 along line 2-2,
- Fig. 3: is a schematic illustration of a cord, according to the invention, connected to a distributor, and
- Fig. 4: is an exemplary block diagram of a controlling arrangement.

### DETAILED DESCRIPTION OF THE EMBODIMENTS

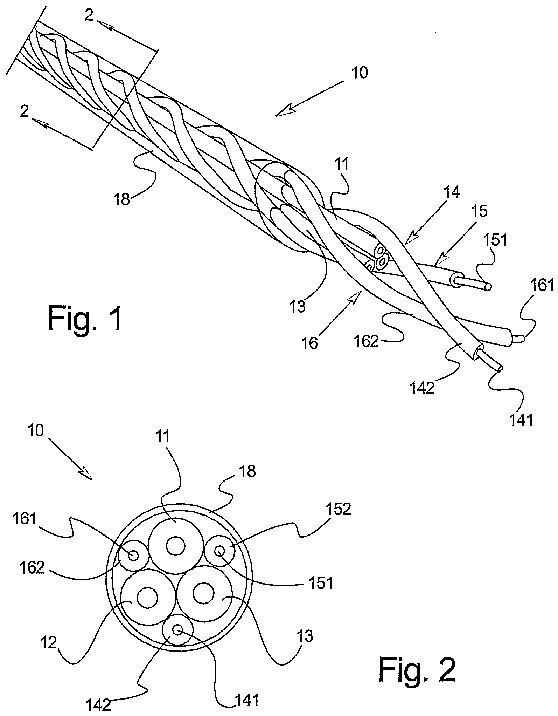

Figs. 1 and 2 illustrate an exemplary embodiment of the invention comprising a cord arrangement 10 including three ordinary electrical wires 11, 12 and 13 arranged around a centre axis. The electrical wires may extend parallel to the centre axis, as shown in Fig. 1, but may also be arranged in a twisted configuration around the centre axis. According to the present example, the three wires may be arranged as power, ground and neutral. The invention can be realised by twisting a number of illuminating wires 14, 15 and 16, which include conductors 141, 151 and 161 coated by an illuminating coating 142, 152 and 162, respectively.

The illuminating wires may be of the type known as electroluminescents, such as described in US 2005037233, WO 031/05538, US 2004067387, WO 03/093394, US 2002/0039666, US 5,485,355 etc. The illuminating wires may also comprise of wires manufactured under trademark Lytec ® by ELAM ltd.

The illuminating wires may also comprise optical fibres, preferably side-emitting optical fibres.

The twisted electrical wires and illuminating wires are covered by a light transparent or semi transparent coating 18, for example made of silicon, rubber etc.

It is appreciated by a skilled person that the present invention is not limited to three illuminating wires and the invention may be applied using any number of illuminating wires and/or electrical wires.

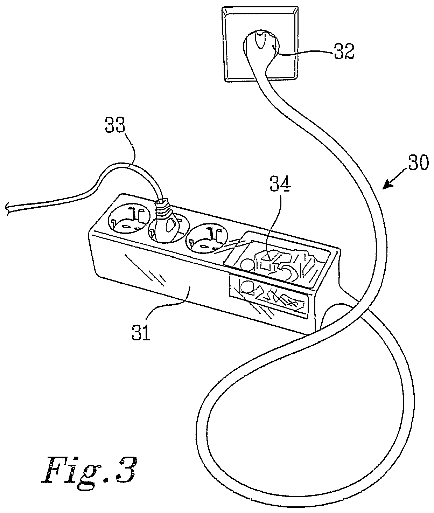

Fig. 3 illustrates one application of the invention as a cord 30 of a distributor 31. The distributor 31 is connected to a wall socket 32. An electric equipment (not shown) is connected to the distributor through a plug 33. The cord is provided with the illuminating wires as mentioned earlier. It is also possible to provide the distributor and the wall plug itself with illuminating wires and consequently using them as part of the indicator.

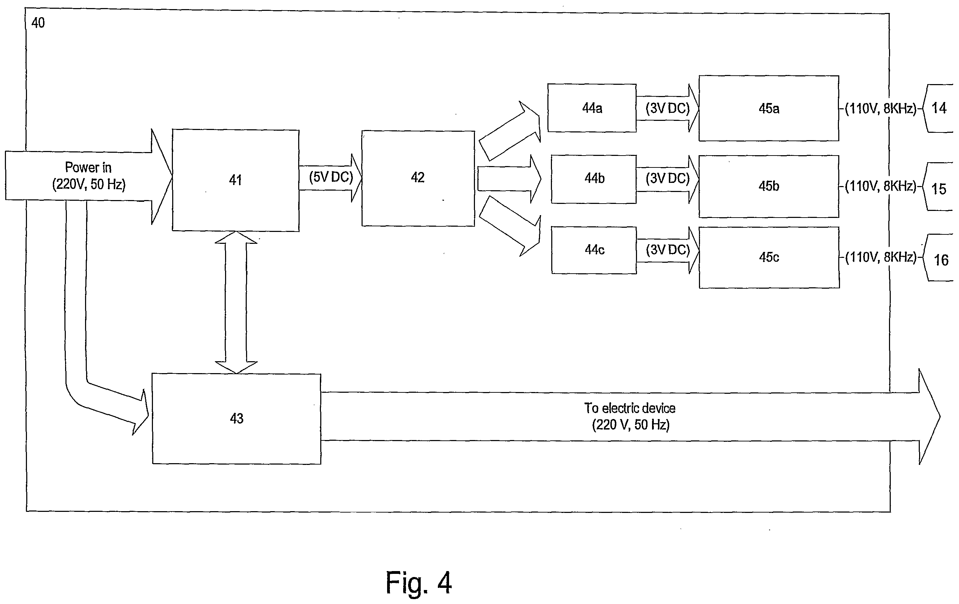

The illumination wires are connected to a controlling arrangement 34, in this case arranged inside the distributor.
An exemplary controlling arrangement is described in the following in conjunction with the block diagram of Fig. 4.

Power to the controlling arrangement 40 is supplied through a power supply 41, which is connected to, for example, a wall socket through the cord 30. The power is adapted to the power level of the electronics in the controlling arrangement. The power supplier converts the power from AC to DC. A processing unit 42, such as a micro computer is arranged to process the information on power level or current amount received from a measuring arrangement 43.

The measuring arrangement 43 is arranged between the wall socket and before connection to an electric equipment so that the power and/or current consumption can be measured. The measuring arrangement may sample current and voltage cautiously and provide data to the micro computer. The power is product of current multiplied with voltage. In the event of stable voltage, the phase shift can be ignored and the current can be measured and used to approximate the power. Thus, the difference between the visualisation of current consumption and power consumption can be minimized.

The micro computer controls, in this example, three pulse width modulators (PWMs) 44a-44c for controlling analog circuits with a processor's digital outputs. The number of PWMs corresponds to the number of illuminating wires. The PWMs are connected to drivers 45a-45c, which operate in a suitable range, e.g. 0-110 V, 8 KHz. The illuminating wires are connected to the drivers and thus operate in the output range of the inverter modules. The drivers may be inverter modules.

In case of optical fibers, the drivers may be connected to intensity and/or pulse controlled light sources, such as light emitting diodes (LED) connected to one end of the fibers.

Depending on the current/voltage through the electrical wires, the micro computer will output suitable control signal to the drivers, which feeds the illuminating wires with varying current, voltage and frequency corresponding to the consumed current/voltage through the electrical wires.

In a preferred embodiment, the electroluminescent wires includes a central copper wire coated with a phosphorus material coating and two tiny transmitter wires wrapped around it, and covered by a PVC coating and finally a colored vinyl coat. The driver takes the voltage from a DC power source and inverts it to, e.g. 110 volts AC. When connected to a power source and driver, the charge creates a glow in the wire, e.g. very similar to neon.

Thus, the controlling arrangement controls the illuminating characteristics, e.g. intensity, color and/or pulsing (frequency) of the illuminating wires in relation to the consumed power and/or current through the electric wires. This allows obtaining a simultaneous characteristic change, shifting the pulsing in the wires to obtain visual effects such as flowing light, etc.

It should be appreciated by a skilled person that the aforementioned controlling arrangement, and input and output values are given as an example and other types of controlling arrangement operating with different electrical values may occur.

The invention is not limited to applications in cables and cords, especially distributor cords; the invention may likewise be applied in household appliance for providing visual indication of poser consumption of different appliances. In industrial and construction site applications, the visualization may be used for indicating overload. Especially, if many apparatuses are connected, it is possible to track a particular apparatus being overloaded or consuming high power by following the visually indicating cable. The visualization allows finding cables in limited sight situations.

The invention is not limited to the shown embodiments but can be varied in a number of ways without departing from the scope of the appended claims and the arrangement can be implemented in various ways depending on application, functional units, needs and requirements etc.

## Claims

1. An arrangement (10, 30) for visual indication of an electrical quantity, said electrical quantity being a level of current and/or power consumption of one or several apparatuses, the arrangement comprising a power cable having a conductor (11, 12, 13) for transmitting current to said one or several apparatuses, wherein the arrangement further comprises a wire shaped illuminator (14, 15, 16) and a controller (34, 40), said controller (34, 40) comprising:
a measuring arrangement (43) for measuring said level of current and/or power consumption;
a processing arrangement (42) for adapting a control signal to control at least one illumination characteristic of said illuminator with respect to said electrical quantity, wherein said at least one illumination characteristic is one or several of intensity, colour or frequency, and
a driver (45a-45c) for driving said illuminator receiving the control signal from said processing arrangement,
wherein said wire shaped illuminator is arranged along said conductor (11, 12, 13).

2. The arrangement of claim 1, wherein said wire shaped illuminator is electroluminescent (14, 15, 16).

3. The arrangement of claim 1, wherein said wire shaped illuminator is an optical fibre.

4. The arrangement of claim 2, wherein said electroluminescent includes a central conductive wire (141, 151, 161) coated with a phosphorus material coating (141, 152, 162) and transmitter wires wrapped around it, and covered by coating and a colored vinyl coat.

## Patentansprüche

1. Anordnung (10,30) zum visuellen Anzeigen einer elektrischen Menge, wobei die elektrische Menge eine Stromstärke und/oder ein Leistungsverbrauch einer oder mehrerer Einrichtungen ist, wobei die Anordnung ein Leistungskabel umfasst, das einen Leiter (11, 12, 13) zum Übertragen von Strom an die eine oder mehreren Einrichtungen aufweist,
wobei die Anordnung weiter einen drahtförmigen Beleuchter (14, 15, 16) und eine Steuereinheit (34, 40) umfasst, wobei die Steuereinheit (34, 40) umfasst:
eine Messanordnung (43) zum Messen der Stromstärke und/oder des Leistungsverbrauchs;
eine Verarbeitungsanordnung (42) zum Einstellen eines Steuersignals, um mindestens eine Beleuchtungscharakteristik des Beleuchters in Bezug auf die elektrische Menge zu steuern, wobei die mindestens eine Beleuchtungscharakteristik eine oder mehrere von Intensität, Farbe oder Frequenz ist, und
einen Treiber (45a-45c) zum Treiben des Beleuchters, der das Steuersignal von der Verarbeitungsanordnung empfängt,
wobei der drahtförmige Beleuchter entlang des Leiters (11, 12, 13) angeordnet ist.

2. Anordnung nach Anspruch 1, wobei der drahtförmige Beleuchter elektrolumineszent (14, 15, 16) ist.

3. Anordnung nach Anspruch 1, wobei der drahtförmige Beleuchter ein Lichtwellenleiter ist.

4. Anordnung nach Anspruch 2, wobei die Elektrolumineszenz einen mittleren leitenden Draht (141, 151, 161) einschließt, der mit einer Beschichtung aus Phosphormaterial (141, 152, 162) und um diese gewickelte Übertragungsdrähte beschichtet ist, und von einer Beschichtung und einer gefärbten Vinylschicht bedeckt ist.

## Revendications

1. Agencement (10, 30) d'indication visuelle d'une quantité électrique, ladite quantité électrique étant un niveau de consommation de courant et/ou de puissance d'un ou de plusieurs appareils, l'agencement comprenant un câble d'alimentation présentant un conducteur (11, 12, 13) pour transmettre un courant auxdits un ou de plusieurs appareils,
dans lequel l'agencement comprend en outre un illuminateur en forme de fil (14, 15, 16) et un dispositif de commande (34, 40), ledit dispositif de commande (34, 40) comprenant :
un agencement de mesure (43) pour mesurer ledit niveau de consommation de courant et/ou de puissance ;
un agencement de traitement (42) pour adapter un signal de commande pour commander au moins une caractéristique d'éclairage dudit illuminateur par rapport à ladite quantité électrique, dans lequel ladite au moins une caractéristique d'éclairage est une ou plusieurs parmi une intensité, une couleur ou une fréquence, et
un pilote (45a-45c) pour piloter ledit illuminateur recevant le signal de commande à partir dudit agencement de traitement
dans lequel ledit illuminateur en forme de fil est agencé le long dudit conducteur (11, 12, 13).

2. Agencement selon la revendication 1, dans lequel ledit illuminateur en forme de fil est électroluminescent (14, 15, 16).

3. Agencement selon la revendication 1, dans lequel ledit illuminateur en forme de fil est une fibre optique.

4. Agencement selon la revendication 2, dans lequel ledit électroluminescent inclut un fil conducteur central (141, 151, 161) revêtu d'un revêtement de matériau phosphoré (141, 152, 162) et des fils émetteurs enroulés autour de celui-ci, et recouvert d'un revêtement et d'un couche en vinyle colorée.
